# EUROPÄISCHE PATENTSCHRIFT

(11) **EP 2 418 777 B1**
(45) Veröffentlichungstag und Bekanntmachung des Hinweises auf die Patenterteilung: **25.12.2013**
(21) Anmeldenummer: 10172248.6
(22) Anmeldetag: 09.08.2010
(51) Int. Cl.: H03K 17/96

(54) **Kapazitiver Schalter**
Capacitative switch
Commutateur capacitif

(43) Veröffentlichungstag der Anmeldung: 15.02.2012
(73) Patentinhaber: RAFI GmbH & Co. KG, 88276 Berg (DE)
(72) Erfinder: Bulach, Eric, 88074, Meckenbeuren (DE)
(74) Vertreter: Engelhardt & Engelhardt

(56) Entgegenhaltungen:
- EP-A1- 1 589 407
- WO-A1-2008/103943
- WO-A2-2009/095848
- US-B1- 7 244 901

## Beschreibung

Die Erfindung bezieht sich auf einen kapazitiven Schalter nach dem Oberbegriff des Patentanspruches 1.

Die Offenbarung der US-7,244,901 B1 bezieht sich auf ein kapazitives Touchpad mit einer Abdeckplatte, die in einen Rahmen eingesetzt ist und durch die eine Leiterplatte nach Außen abgedeckt ist. Desweiteren weist der kapazitive Touchpad eine Vielzahl von leitfähigen Schichten auf, die als Segmente ausgestellt sind und jeweils ein eigenständiges kapazitives Feld ausbilden.

Da jedes der Segmente nachteiligerweise ein eigenständiges Kapazitätsfeld aufweist, ist zwar über die Oberfläche der Abdeckplatte eine gleichförmige Feldstruktur vorhanden, die sowohl in X- als auch in Y-Richtung homogen wirkt, jedoch sind die Abstrahlhöhen der einzelnen Magnetfelder extrem niedrig bemessen. Die Segmente sind seitlich sehr klein in Ihrer Fläche strukturiert, so dass keine hohen Feldstärken erreicht werden können. Auch weist die beschichtete Anordnung keinerlei Verstärkungsfunktionen auf, durch die die Abstrahlhöhe optimiert bzw. vergrößert ist. Um den Randbereich des Rahmens zu verkleinern, sind in diesem Bereich lediglich Bahnen vorgesehen, durch die das jeweilige kapazitive Feld abgelenkt ist.

Solche kapazitiven Schalter werden in einer Vielzahl von Anwendungen eingesetzt. Das von der Kupferschicht erzeugte Kapazitätsfeld wird dabei in Richtung einer Bedienoberfläche abgestrahlt. Sobald das Kapazitätsfeld, beispielsweise durch das Eindringen eines menschlichen Fingers, gestört ist, verändert sich dessen Wert.

Durch einen zu der Kupferschicht benachbart angeordneten integrierten Schaltkreis werden diese Veränderungen des Kapazitätsfeldes permanent gemessen, so dass durch einen elektrisch mit dem integrierten Schaltkreis gekoppelten Mikrocontroller ein elektrisches Schaltsignal erzeugbar ist, wenn das Kapazitätsfeld der Kupferschicht einen voreingestellten Grenzwert unter- oder überschreitet.

Es besteht daher seit mehreren Jahren ein erheblicher Bedarf, dass die bekannten kapazitiven Schalter auch in anderen elektrischen Geräten verwendet werden kön-nen, deren Schalt- und Steuerfunktion zuverlässig und dauerhaft erfolgen soll, da diese kapazitiven Schalter ein bestimmtes Maß an Schaltsicherheit über deren gesamte Fläche aufweisen müssen.

Darüber hinaus hat sich das Problem ergeben, dass die von den Metallschichten erzeugten kapazitiven Felder eine äußerst geringe räumliche Ausdehnung aufweisen, da die kapazitiven Feldlinien im Wesentlichen kuppel- oder domförmig, ober- und unterhalb der jeweiligen Metalischicht ausgebildet sind. Der Einsatzbereich solcher kapazitiven Schalter ist daher auf die manuelle Bedienbarkeit begrenzt, denn ausschließlich durch das definierte Eindringen eines menschlichen Fingers in ein solches kapazitives Feld kann ein entsprechende elektrisches Schaltsignal generiert werden.

Die räumlich begrenzte Ausdehnung solcher kapazitiven Felder führt nachteiliger Weise dazu, dass bereits geringe Störungen ein Schaltsignal auslösen oder aber die Ausbildung des kapazitiven Feldes verhindert und folglich die Schaltfunktion gestört ist. Insbesondere wenn Schmutzpartikel oder feinste Wassertröpfchen, die zu Reinigungszwecken in sanitären Bereich eingesetzt werden, auf die Bereiche der Abdeckplatte anhaften, auf denen die kapazitiven Felder verlaufen, dann führen solche Schmutzpartikel oder Wassertropfen zu Fehlfunktionen.

Es ist daher Aufgabe der Erfindung, einen kapazitiven Schalter der eingangs genannten Gattung derart weiterzubilden, dass das von dem kapazitiven Schalter erzeugte kapazitive Feld eine möglichst raumgreifende Abmessung einnimmt, dass also das kapazitive Feld möglichst weit von der Schicht abgestrahlt ist, so dass bereits bei einem möglichst groß bemessenen Schaltabstand ein elektrisches Schaltsignal generiert werden kann, wenn das kapazitive Feld beeinflusst ist. Gleichzeitig soll gewährleistet sein, dass Schmutzpartikel oder Wassertropfen die räumliche Ausdehnung des kapazitiven Feldes nicht behindern, und dass durch die Wassertropfen oder Schmutzpartikel die Schaltfunktion des kapazitiven Schalters nicht beeinflusst ist. Dabei soll die räumliche Ausdehnung des kapazitiven Feldes auch in dessen Randbereich möglichst homogen sein und von der Schicht möglichst gleichmäßig abstrahlen.

Die Aufgaben sind erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die Segmente elektrisch mit der Leiterplatte verbunden sind, erzeugt jedes dieser Segmente ein nach außen abgestrahltes kapazitives Feld, dessen räumliche Ausdehnung größer bemessen ist als die kapazitiven Felder von einem einzigen durchgehenden Segment, da durch die räumliche Trennung der Segmente die Ausdehnung der kapazitiven Feldlinien von der Leiterplatte weiter in den Raum verläuft. Insbesondere wenn die Segmente um einen gemeinsamen Mittelpunkt, beispielsweise auf einer Kurvenbahn, die sich um diesen Mittelpunkt erstreckt oder auf einer gemeinsamen Linie angeordnet sind, die miteinander eine mehreckförmige Fläche bilden, ist gewährleistet, dass die räumliche Ausdehnung der kapazitiven Felder von dem Mittelpunkt und auch im Randbereich weiter entfernt als bisher bekannt verläuft, so dass der Schaltabstand erheblich vergrößert ist im Vergleich mit den bekannten und konzeptionell andersartig ausgestalteten Metallschichten.

Es ist besonders vorteilhaft, wenn die einzelnen Segmente ringförmig um den gemeinsamen Mittelpunkt angeordnet sind und wenn die Segmente einen bestimmten vorgegebenen Abstand zu dem gemeinsamen Mittelpunkt einnehmen, so dass zum Einen zwischen dem gemeinsamen Mittelpunkt und dem unmittelbar benachbarten Segment keine elektrisch leitfähige Schicht vorhanden ist und wenn zwischen den einzelnen Segmenten eine ringförmig ausgestaltete nicht elektrisch leitende Schicht der Leiterplatte vorgesehen ist, um dadurch die räumliche Ausdehnung des Kapazitätsfeldes des jeweiligen Segmentes von diesem nach außen anzuheben.

Die erfindungsgemäßen kapazitiven Schalter können beispielsweise im Sanitärbereich eingesetzt werden, um die Spülung einer Toilette zu steuern. Der Benutzer der Toilette beeinflusst nämlich bereits beim Herantreten den kapazitiven Schalter, so dass dieser ohne Weiteres erkennt, dass eine Spülfunktion auszulösen ist, sobald der Benutzer das kapazitive Feld verlässt. Zudem sind solche kapazitiven Schalter in ihrer Herstellung wesentlich kostengünstiger anzufertigen als die bislang eingesetzten optischen Schaltsysteme, deren einzelne Bauteile in der Herstellung äußerst kostenintensiv sind.

In der Zeichnung ist ein erfindungsgemäßes Ausführungsbeispiel mit unterschiedlichen räumlichen Ausgestaltungsmöglichkeiten von kapazitiven Schaltern dargestellt, die nachfolgend erläutert sind. Im Einzelnen zeigt:

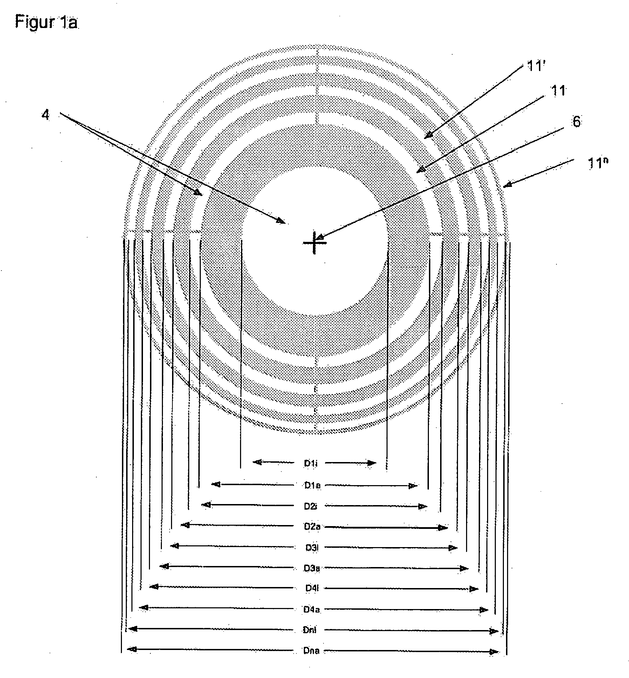

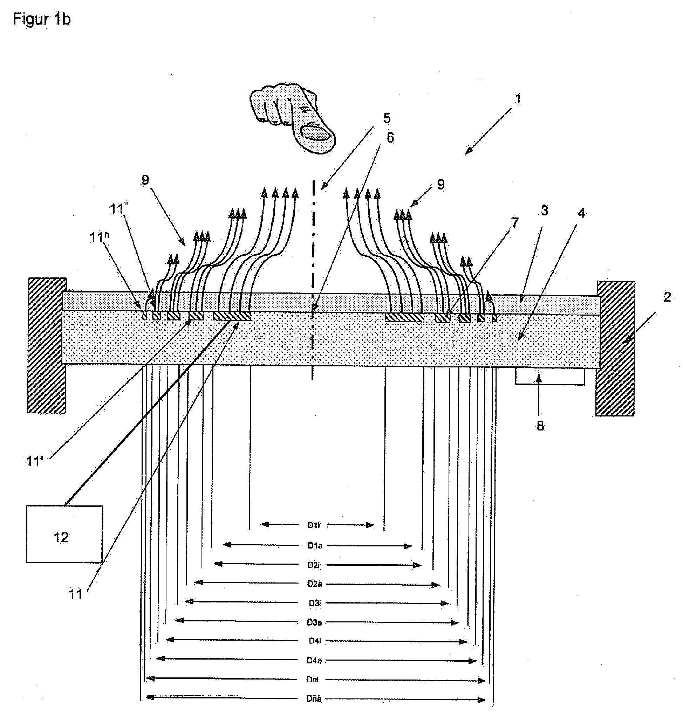

- Figur 1 a: fünf Segmente eines kapazitiven Schalters, die um einen gemeinsamen Mittelpunkt angeordnet sind, die galvanisch miteinander verbunden sind und auf einer gemeinsamen Leiterplatte angeordnet sind, in Draufsicht,
- Figur 1 b: den kapazitiven Schalter gemäß Figur 1a, im Schnitt und die schematisch dargestellte Ausbildung der kapazitiven Felder der jeweiligen Segmente,
- Figur 2a: eine andersartige Anordnung der Segmente des kapazitiven Schalters gemäß Figur 1 a, in Draufsicht,
- Figur 2b: eine weitere andersartige Ausgestaltung der einzelnen Segmente des kapazitiven Schalters gemäß Figur 1 a,
- Figur 2c: eine Vielzahl von Segmenten, die galvanisch miteinander verbunden sind und um einen gemeinsamen Mittelpunkt eines des kapazitiven Schalters gemäß Figur 1 a angeordnet sind; und
- Figur 3: den Schalter gemäß Figur 1 a mit einer weiteren Schicht, die als durchgehende Fläche ausgebildet und unterhalb der fünf Segmente angeordnet ist.

In den Figuren 1 a und 1 b ist ein kapazitiver Schalter 1 zu entnehmen, durch den ein kapazitives Feld 9 erzeugt ist, das mindestens fünf bis zehn Zentimeter in den Raum abstrahlt. Der kapazitive Schalter 1 soll nämlich die elektrische Steuerung, beispielsweise von Toilettenspülungen übernehmen, so dass beim Herantreten das kapazitive Feld 9 gestört und beim Entfernen der ursprüngliche Wert des kapazitiven Feldes 9 wieder hergestellt ist, so dass eine dem kapazitiven Schalter 1 zugeordnete Auswerteeinheit 12 ein elektrisches Schaltsignal zur Betätigung der Toilettenspülung generiert.

Der kapazitive Schalter 1 besteht aus einem Gehäuserahmen 2, der schematisch dargestellt ist. In dem Gehäuserahmen 2 ist eine Abdeckplatte 3 angeordnet, durch die Schmutzpartikel, Wassertropfen und sonstige Verunreinigungen von der im Inneren des Gehäuserahmens 2 vorgesehene Leiterplatte 4 abgehalten sind. Die Abdeckplatte 3 ist aus Glas, Kunststoff oder Holz gefertigt; durch diese Werkstoffe tritt das kapazitive Feld 9 ungestört hindurch.

In der Leiterplatte 4 sind fünf Schichten 7 aus einem metallischen Werkstoff, vorzugsweise aus Kupfer vorgesehen, die einem oder mehreren integrierten Schaltkreise 8 oder Schaltkreisen 8 zugeordnet sind. Die integrierten Schaltkreise 8 messen die Veränderungen des kapazitiven Feldes 9 und sind elektrisch mit der Auswerteeinheit 12 verbunden.

Die Schichten 7 sind im gezeigten Ausführungsbeispiel ringförmig um einen gemeinsamen Mittelpunkt 6 angeordnet, der auf der Längsachse 5 liegt. Die Längsachse 5 verläuft senkrecht zu der Leiterplatte 4. Um jede der Längsachsen 5 bzw. dem Mittelpunkt 6 sind demnach die Segmente 11, 11' .... 11ⁿ vorgesehen. Jedes der Segmente 11 bis 11ⁿ ist galvanisch mit der Leiterplatte 4 verbunden, so dass durch diese das homogene kapazitive Feld 9 erzeugt ist, dessen räumliche Ausdehnung mindestens fünf Zentimeter oberhalb der Abdeckplatte 3 verläuft. Folglich ist die Veränderung des kapazitiven Feldes 9 bereits dann messbar, wenn in einem Bereich von 10 oder weniger Zentimetern ein menschliches Körperteil eindringt und dadurch den Wert des kapazitiven Feldes 9 verändert. Insbesondere in dem Randbereich, der dem äußeren Segment 11ⁿ zugeordnet ist, verläuft das kapazitive Feld 9 nahezu homogen zu den inneren Feldlinien des kapazitiven Feldes 9, wodurch auch eine zuverlässige Schaltung entsteht, wenn lediglich im Randbereich eine Störung in das kapazitive Feld 9 eindringt.

Die einzelnen Segmente 11 bis 11ⁿ können in ihrer Wandstärke gleich groß bemessen sein. Es hat sich jedoch herausgestellt, dass zum Einen der Abstand zwischen dem gemeinsamen Mittelpunkt 6 und dem nächstliegenden benachbarten Segment 11 möglichst doppelt so groß zu bemessen ist wie die Wandstärke dieses Segmentes 11. Darüber hinaus sollten die Wandstärken der Segmente 11 bis 11ⁿ in einem vorgegebenen Verhältnis von 1 : 2 von innen nach außen bezogen auf den gemeinsamen Mittelpunkt 6 abnehmen. Durch die Reduzierung der Wandstärken der einzelnen Segmente 11 bis 11ⁿ ist erreicht, dass die räumliche Ausdehnung in Richtung der Längsachse 5 des kapazitiven Feldes 9 von innen nach außen möglichst gleichmäßig abnimmt.

Der Abstand zwischen zwei benachbarten Segmenten 11 und 11' bzw. 11' und 11" usw. ist dabei konstant gehalten und beträgt im Ausführungsbeispiel etwa drei Millimeter. Es ist jedoch auch ohne Weiteres denkbar, die Abstände zwischen den benachbarten Segmenten 11 und 11' bzw. 11' und 11" usw. von innen nach außen zu verkleinern oder zu vergrößern, um dadurch die räumliche Ausbildung des kapazitiven Feldes 9 an die entsprechende Schaltfunktion anzupassen.

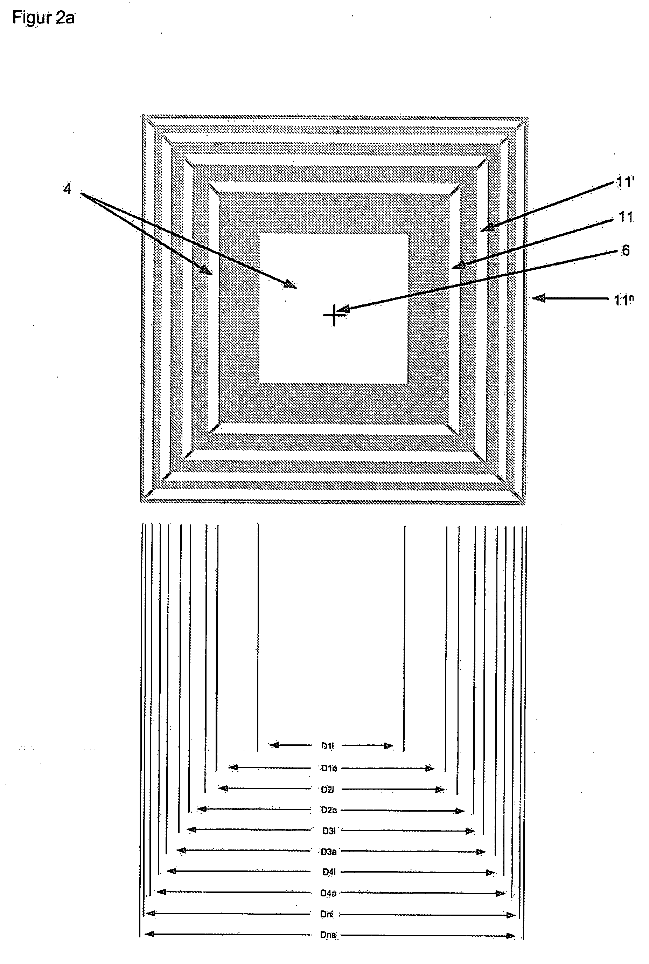

Aus Figur 2a ist eine quadratische Ausgestaltung der Segmente 11 bis 11ⁿ dargestellt. Dabei verlaufen die Abstände eines der Segmente 11 bzw. 11' usw. in einem konstanten Abstand zu dem gemeinsamen Mittelpunkt 6.

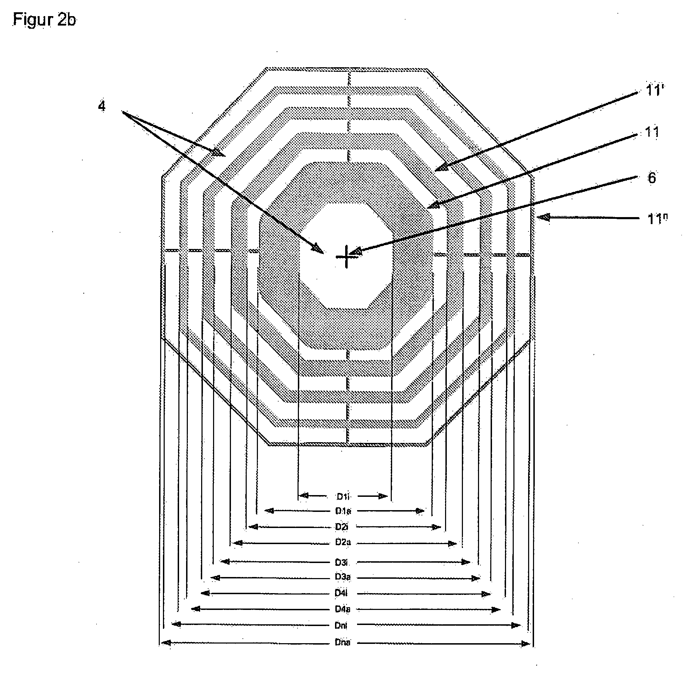

In Figur 2b ist eine achteckige Ausgestaltung der Segmente 11 bis 11ⁿ abgebildet. Die einzelnen Teilabschnitte der Segmente 11 bis 11ⁿ liegen auf einer Linie, die im Wesentlichen den gleichen Abstand zu dem Mittelpunkt 6 aufweist.

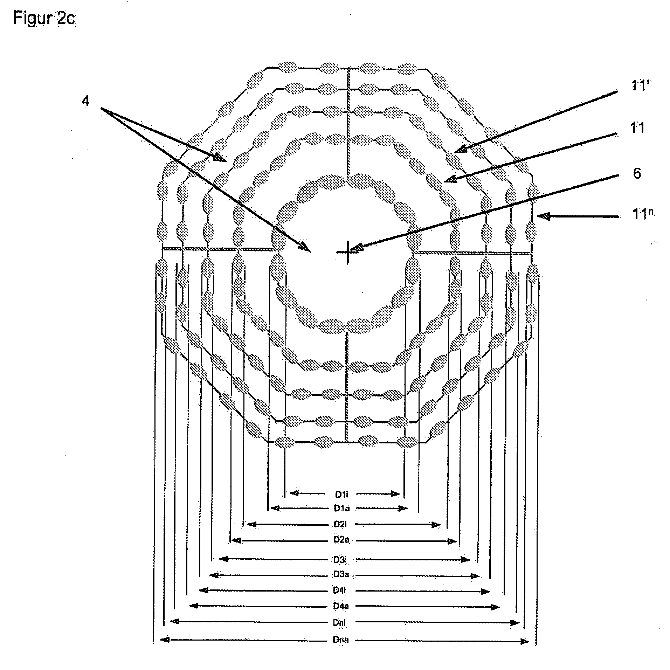

In Figur 2c ist eine weitere Ausgestaltung der Segmente 11 bis 11ⁿ zu entnehmen, die nunmehr punktuell, also nicht als durchgehende Ringfläche bzw. als mehreckige Struktur um den gemeinsamen Mittelpunkt 6 angeordnet sind, sondern die vielmehr für sich betrachtet eine bestimmte, beispielsweise elliptische Flächenausdehnung aufweisen.

Sämtlichen den Ausführungsbeispielen der Figuren 1a bis 2c beschriebenen Segmenten 11 bis 11ⁿist gemeinsam, dass die Segmente 11 bis 11ⁿ galvanisch miteinander verbunden sind und dadurch das gemeinsame kapazitive Feld 9 ausbilden. Es ist jedoch ohne Weiteres möglich, einzelne Segmente 11 bis 11ⁿ an unterschiedliche integrierte Schaltkreise 8 anzuschließen, so dass durch diese verschiedene kapazitive Felder 9 entstehen. Dies erhöht beispielsweise die Schaltsicherheit des Schalters 1, denn dann können die integrierten Schaltkreise 8 unabhängig voneinander die Veränderungen der unterschiedlichen kapazitiven Felder 9 messen und diese Informationen an die Auswerteeinheit 12, die beispielsweise als Mikrocontroller ausgebildet ist, weiterleiten. Durch die Auswerteeinheit 12 wird festgestellt, ob tatsächlich eine Schaltung beabsichtigt gewesen ist oder ob eine Störfunktion vorliegt, so dass durch die erläuterte Schaltung der einzelnen Segmente 11 bis 11ⁿ eine redundante Schaltfunktion geschaffen ist.

Dadurch, dass das kapazitive Feld 9 etwa fünf bis zehn Zentimeter oder mehr von der Abdeckplatte 3 abstrahlt, stören auch Schmutzpartikel oder Wassertropfen, die sich um den gemeinsamen Mittelpunkt 6 der jeweiligen Schicht 7, insbesondere auf der Oberfläche der Abdeckplatte 3 anhaften, die räumliche Ausdehnung des kapazitiven Feldes 9 nicht. Somit kann die Abdeckplatte 3 ohne Weiteres gereinigt werden und unmittelbar nach dem Reinigungsvorgang ist der Schalter 1 wieder betriebsbereit.

Der für die Abdeckplatte 3 verwendete Werkstoff stört die Ausbildung des kapazitiven Feldes 9 nicht. Aufgrund der räumlichen Ausdehnung des kapazitiven Feldes 9 ist es nunmehr auch möglich, die Abdeckplatte 3 plan oder in unterschiedlichen Höhenniveaus auszugestalten. Beispielsweise könnte die Abdeckplatte 3 um den jeweiligen Mittelpunkt 6 eines der Schichten 7 eine stufenförmige Außenkontur aufweisen oder die Abdeckplatte 3 ist um den gemeinsamen Mittelpunkt 6 bzw. die Achse 5 kuppel- oder domförmig ausgestaltet, so dass auf der Oberfläche der Abdeckplatte 3 Noppen oder dgl. entstehen, die die Bedienung der einzelnen den Segmenten 11 bis 11ⁿ zugeordneten Schaltflächen vereinfachen.

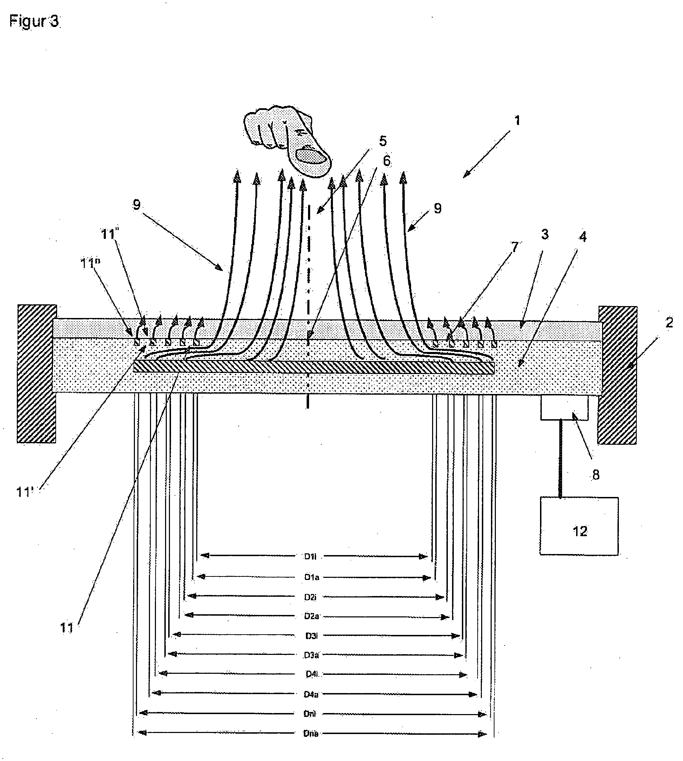

Aus Figur 3 ist eine Weiterbildung des kapazitiven Schalters 1 nach den Figuren 1a und 1 b zu entnehmen. Zusätzlich zu den fünf Segmenten 11 bis 11ⁿ ist auf der Leiterplatte 4 eine Schicht 7 vorgesehen, deren Struktur durchgehend ist. Diese Schicht 7 bildet ebenfalls ein kapazitives Feld 9 aus, das insbesondere im Bereich um die Längsachse 5 eine erhöhte räumliche Ausdehnung einnimmt, denn zwischen der Längsachse 5 und dem zu diesem nächstliegenden benachbarten Segment 11 ist keine metallische Abschirmung vorhanden, so dass durch die derart geschaffene elektrisch wirksame Durchgangsöffnung für die Feldlinien des kapazitiven Feldes 9 eine Bündelung geschaffen ist. Die Schicht 7 ist dabei unterhalb zu den Segmenten 11 bis 11ⁿ angeordnet, so dass diese zwischen der Abdeckplatte 3 und der Schicht 7 verlaufen. Die zusätzliche durchgehende Schicht 7 ist galvanisch mit den Segmenten 11 bis 11ⁿ verbunden, so dass diese das gemeinsame kapazitive Feld 9 erzeugen. Der Durchmesser oder die Kantenlänge der durchgehenden Schicht 7 entspricht dem äußeren Durchmesser oder Kantenlänge des Segmentes 11ⁿ.

Insbesondere im Bereich der Segmente 11 bis 11ⁿ wird das von der Schicht 7 erzeugte kapazitive Feld 9 abgeschirmt, so dass dieses erst dann durch die Abdeckplatte 3 durchtreten kann, wenn die Öffnung zwischen der Längsachse 5 und dem zu dieser benachbarten Segment 11 erreicht ist.

## Patentansprüche

1. Kapazitiver Schalter (1), bestehend aus einem Gehäuserahmen (2), durch den eine Abdeckplatte (3) gehalten ist, aus einer parallel und beabstandet zu der Abdeckplatte (3) verlaufender oder plan an dieser anliegenden Leiterplatte (4) und aus einer elektrisch leitfähigen auf der Leiterplatte (4) aufgebrachten Schicht (7), die galvanisch mit der Leiterplatte (4) verbunden ist, wobei die Schicht (7) aus mindestens zwei voneinander getrennten Segmenten (11, 11', 11 ", ...11ⁿ) gebildet ist, und wobei jedes der Segmente (11, ..., 11ⁿ) um einen und beabstandet zu einem gemeinsamen Mittelpunkt angeordnet ist,
**dadurch gekennzeichnet,**
**dass** die Segmente (11, ..., 11ⁿ) elektrisch miteinander verbunden sind und durch die jeweils ein kapazitives Feld (9) erzeugt ist, dass jedes der Segmente (11, ..., 11ⁿ) it einem oder mehreren integrierten Schaltkreise (8) verbunden ist durch den oder die eine Veränderung des kapazitiven Feldes (9) des jeweiligen Segmentes (11, ..., 11ⁿ) messbar ist, dass jedes der Segmente (11, ..., 11ⁿ) aus einer um den gemeinsamen Mittelpunkt (6) verlaufenden durchgehenden Struktur gebildet ist und dass zwei dieser benachbarten Segmente (11 und 11' oder 11' oder 11" usw.) unterschiedlich groß bemessene Radien oder Abstände bezogen auf den gemeinsamen Mittelpunkt (6) aufweisen.

2. Kapazitiver Schalter nach Anspruch 1,
**dadurch gekennzeichnet,**
**dass** jedes der Segmente (11, ..., 11ⁿ) eine radiale Abmessung (D_{A} - D_{I}) aufweist, die kleiner bemessen ist als der Abstand des jeweiligen Segmentes um den gemeinsamen Mittelpunkt (6).

3. Kapazitiver Schalter nach Anspruch 1 oder 2,
**dadurch gekennzeichnet,**
**dass** jedes der Segmente (11, ..., 11ⁿ) bogenförmig gekrümmt oder linear verlaufend ausgestaltet ist.

4. Kapazitiver Schalter nach Anspruch 1,
**dadurch gekennzeichnet,**
**dass** das dem Mittelpunkt (6) unmittelbar benachbart angeordnete Segment (11) eine in radialer Richtung verlaufende größere Wandstärke aufweist als das dazu nächstfiegende Segment (11') und dass die Wandstärken der Segmente (11, ..., 11ⁿ) bezogen auf den Mittelpunkt (6) von innen nach außen, vorzugsweise in einem Verhältnis von 1 : 2, abnehmen.

5. Kapazitiver Taster nach einem der Ansprüche 1 oder 4,
**dadurch gekennzeichnet,**
**dass** die umlaufenden Segmente (11, ..., 11ⁿ) ringförmig, mehreckförmig oder elliptisch ausgebildet sind.

6. Kapazitiver Schalter nach einem der vorgenannten Ansprüche,
**dadurch gekennzeichnet,**
**dass** um den gemeinsamen Mittelpunkt (6) und dem dazu nächstliegenden Segment (11) die elektrisch nicht leitfähige. Leiterplatte (4) verläuft und dass der Abstand zwischen dem Mittelpunkt (6) und dem dazu nächstliegenden Segment (11) mindestens doppelt so groß bemessen ist wie die radiale Wandstärke dieses Segmentes (11).

7. Kapazitiver Taster nach einem der vorgenannten Ansprüche,
**dadurch gekennzeichnet,**
**dass** die Schicht aus Kupfer (7), ITO, Leitfack oder sonstigen elektrisch leitfähigen Materialien hergestellt ist.

8. Kapazitiver Taster nach einem der vorgenannten Ansprüche,
**dadurch gekennzeichnet,**
**dass** die außen verlaufende Kontur der Abdeckplatte (3) plan oder stufen-oder kuppelförmig im Bereich der jeweiligen Segmente (11, ..., 11ⁿ) ausgestaltet ist.

9. Kapazitiver Taster nach einem der vorgenannten Ansprüche,
**dadurch gekennzeichnet,**
**dass** die Abdeckplatte (3) aus Glas, Holz oder Kunststoff gefertigt ist.

10. Kapazitiver Taster nach einem der vorgenannten Ansprüche,
**dadurch gekennzeichnet,**
**dass** an der Leiterplatte (4) eine zusätzliche Schicht (7) angeschlossen ist, deren Struktur als durchgehende Fläche ausgestaltet ist und dass diese Schicht (7) räumlich versetzt zu den Segmenten (11 bis 11ⁿ) angeordnet und galvanisch mit diesen verbunden ist.

11. Kapazitiver Schalter nach Anspruch 10,
**dadurch gekennzeichnet,**
**dass** die Außenabmessung der Schicht (7) mit dem Durchmesser des äußeren Segmentes (11ⁿ) übereinstimmt und dass das von der Schicht (7) erzeugte kapazitive Feld (9) im Bereich des Mittelpunktes (6) und zwischen dem benachbart zu diesem angeordneten Segment (11) durch die Abdeckplatte (3) verläuft.

## Claims

1. A capacitative button (1), consisting of a housing frame (2) by means of which a cover plate (3) is held, of a printed circuit board (4) running parallel to and at a distance from the cover plate (3) or in flat contact with it and of an electrically conductive layer (7) applied to the printed circuit board (4) and electrically connected with the printed circuit board (4) in which the layer (7) comprises at least two segments (11, 11', 11", ... 11ⁿ) separated from one another, and in which each of the segments (11, ...., 11ⁿ) is arranged around and at a distance from a common centre point,
**characterised in that**,
the segments (11, ..., 11ⁿ) are electrical connected to one another and each of them generates a capacitative field (9), that each of the segments (11, ..., 11ⁿ) is connected to one or more integrated circuits (8), by means of which a change in the capacitative field (9) of each particular segment (11, ..., 11ⁿ) can be measured, that each of the segments (11, ..., 11ⁿ) is composed of a continuous structure running about the common centre point (6) and that two of these adjacent segments (11 and 11' or 11' or 11" etc.) have differently sized radii or distances in relation to the common centre point (6).

2. The capacitative button in accordance with Claim 1,
**characterised in that**,
each of the segments (11, ..., 11ⁿ) has a radial dimension (D_{A} - D_{I}) that is smaller in size than the distance of the particular segment about the common centre point (6).

3. The capacitative button in accordance with Claim 1 or 2,
**characterised in that**,
each of the segments (11, ..., 11ⁿ) is configured with an arched curvature or runs in a linear direction.

4. The capacitative button in accordance with Claim 1,
**characterised in that**,
the segment (11) arranged directly adjacent to the centre point (6) has a greater wall thickness running in a radial direction that the segment (11') adjacent to that, and that the wall thicknesses of the segments (11, ..., 11ⁿ) reduce from inside towards outside in relation to the centre point (6), preferably in a ratio of 1:2.

5. The capacitative button in accordance with Claims 1 or 4,
**characterised in that**,
the circumferential segments (11, ..., 11ⁿ) are ring-shaped, polygonal or elliptical in configuration.

6. The capacitative button in accordance with one of the aforementioned claims,
**characterised in that**,
the non-electrically conductive printed circuit board (4) runs about the common centre point (6) and the segment (11) located nearest to it, and that the distance between the centre point (6) and the segment (11) located nearest to it is at least twice as large as the radial wall thickness of this segment (11).

7. The capacitative button in accordance with one of the aforementioned claims,
**characterised in that**,
the layer is made of copper (7), ITO, conductive lacquer or other electrically conductive materials.

8. The capacitative button in accordance with one of the aforementioned claims,
**characterised in that**,
the contour of the cover plate (3) running on the outside is configured flat or in a stepped or dome shape in the area of the particular segments (11, ..., 11ⁿ).

9. The capacitative button in accordance with one of the aforementioned claims,
**characterised in that**,
the cover plate (3) is produced from glass, wood or plastic.

10. The capacitative button in accordance with one of the aforementioned claims,
**characterised in that**,
an additional layer (7) is connected to the printed circuit board (4), the structure of which is configured as a continuous surface, and that this layer (7) is spatially offset in relation to the segments (11, 11ⁿ) and is electrically connected to them.

11. The capacitative button in accordance with Claim 10,
**characterised in that**,
the external dimension of the layer (7) matches the diameter of the outer segment (11ⁿ), and that the capacitative field (9) generated by the layer (7) runs in the area of the centre point (6) and between the segment (11) arranged adjacent to this through the cover plate (3).

## Revendications

1. Contacteur capacitif (1) comprenant un cadre (2) qui retient une plaque de recouvrement (3), une platine conductrice (4) prévue parallèle et à une certaine distance de la plaque de recouvrement (3) ou bien portant plane sur celle-ci, une couche conductrice (7) prévue sur la platine conductrice (4) et liée de manière galvanique avec cette platine conductrice (4), la couche (7) étant composée d'au moins deux segments (11, 11', 11", ... 11ⁿ) séparés entre eux, et où chacun des segments (11, ..., 11ⁿ) est disposé autour d'un point central commun et à une certaine distance de celui-ci,
**caractérisé en ce que**
les segments (11, ..., 11ⁿ) ont une liaison électrique entr'eux et produisent respectivement un champ capacitif (9), que chacun des segments (11, ..., 11ⁿ) est lié avec un ou plusieurs circuits intégrés (8) permettant de mesurer un changement du champ capacitif (9) du segment respectif (11, ..., 11ⁿ), que chacun des segments (11, ..., 11ⁿ) est formé par une structure continue s'étendant autour du point central commun (6) et que deux de ces segments voisins (11 et 11' ou 11' ou 11" et.) ont des rayons différents ou des distances différentes par rapport au point central commun (6).

2. Contacteur capacitif d'après la revendication 1,
**caractérisé en ce que**
chacun des segments (11, ..., 11ⁿ) a une dimension radiale (D_{A}-D_{I}) plus petite que l'écartement du segment respectif du point central commun (6).

3. Contacteur capacitif d'après une des revendications 1 ou 2,
**caractérisé en ce que**
chacun des segments (11, ..., 11ⁿ) a la forme d'un arc ou une forme linéaire.

4. Contacteur capacitif d'après la revendication 1,
**caractérisé en ce que**,
en direction radiale, l'épaisseur de la paroi du segment (11) directement voisin du point central commun (6) est plus grande que celle du prochain segment correspondant (11 ') et que, par rapport au point central (6), les épaisseurs de paroi des segments (11, ..., 11ⁿ) diminuent de l'intérieur vers l'extérieur de préférence à raison de 1 : 2.

5. Contacteur capacitif d'après une des revendications 1 ou 4,
**caractérisé en ce que**
les segments (11, ..., 11ⁿ) ont une forme annulaire, polygonale ou elliptique.

6. Contacteur capacitif d'après une des revendications précédentes,
**caractérisé en ce que**,
autour du point central commun (6) et du segment directement voisin (11), il s'étend la platine non conductrice (4), et que l'écartement entre le point central (6) et le segment directement voisin (11) est au moins deux fois plus grand que l'épaisseur de la paroi radiale de ce segment (11).

7. Contacteur capacitif d'après une des revendications précédentes,
**caractérisé en ce que**
la couche consiste en cuivre (7), en ITO, en vernis conducteur ou en un autre matériau conducteur.

8. Contacteur capacitif d'après une des revendications précédentes,
**caractérisé en ce que**,
au niveau des segments respectifs (11, .... 11ⁿ), le contour extérieur de la plaque de recouvrement (3) est formé plane ou en échelons ou en coupole.

9. Contacteur capacitif d'après une des revendications précédentes,
**caractérisé en ce que**
la plaque de recouvrement (3) est fabriquée en verre, en bois ou en matière synthétique.

10. Contacteur capacitif d'après une des revendications précédentes,
**caractérisé en ce que**
sur la platine conductrice (4), il est prévue une couche supplémentaire (7), dont la structure est une surface continue, et que cette couche (7) est espacée des segments (11 à 11ⁿ) et liée de manière galvanique avec ceux-ci.

11. Contacteur capacitif d'après la revendication 10,
**caractérisé en ce que**
la dimension extérieure de la couche (7) correspond au diamètre du segment extérieur (11ⁿ) et que, au niveau du point central (6) et entre le segment voisin (11), le champ capacitif (9) créé par la couche (7) passe à travers la plaque de recouvrement (3).
